# EUROPÄISCHE PATENTSCHRIFT

(11) **EP 2 511 998 B1**
(45) Veröffentlichungstag und Bekanntmachung des Hinweises auf die Patenterteilung: **26.08.2015**
(21) Anmeldenummer: 11162277.5
(22) Anmeldetag: 13.04.2011
(51) Int. Cl.: H02H 3/16, H02H 5/10, H02H 3/04, C01B 33/035, H02H 1/04, H02H 9/08

(54) **Anordnung zur Erdschlussüberwachung in einem Wechselstromkreis und Stromversorgungsanordnung mit einer solchen Erdschlussüberwachung**
Assembly for earth connection surveillance in an alternating current circuit and power supply assembly with such an earth connection surveillance
Agencement de surveillance de défaut à la terre dans un circuit de courant alternatif et agencement d'alimentation en électricité doté d'une telle surveillance de raccordement à la terre

(43) Veröffentlichungstag der Anmeldung: 17.10.2012
(73) Patentinhaber: AEG Power Solutions GmbH, 59581 Warstein-Belecke (DE)
(72) Erfinder: Wallmeier, Peter, 59556 Lippstadt (DE)
(74) Vertreter: Graefe, Jörg

(56) Entgegenhaltungen:
- EP-A1- 0 544 415
- DE-A1-102009 021 403

## Beschreibung

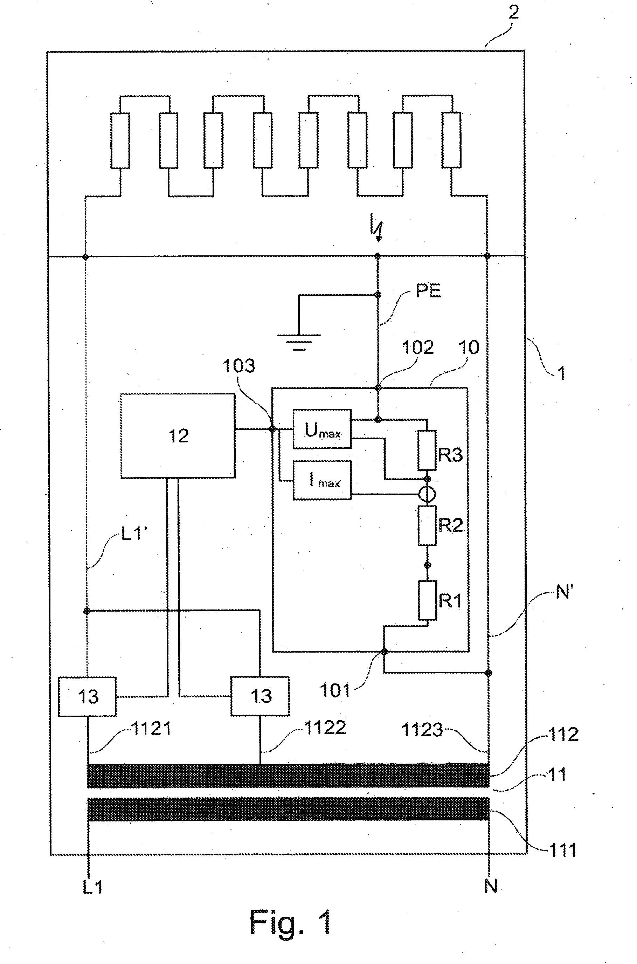

Die vorliegende Erfindung betrifft eine Anordnung zur Erdschlussüberwachung eines Wechselstromkreises zwischen einem Neutralleiter des Wechselstromkreises einerseits und einem Schutzleiter oder einem Erder andererseits. Eine solche Anordnung ist in der Figur 1 dargestellt und mit dem Bezugszeichen 10 bezeichnet. Die Anordnung weist eine Reihenschaltung von ohmschen Widerständen R1, R2, R3 auf, die einen ersten Anschluss 101 für den Neutralleiter N' und einen zweiten Anschluss 102 für den Schutzleiter PE oder den Erder aufweist.

Die Erfindung betrifft ferner eine Stromversorgungsanordnung 1 für einen Polysiliciumreaktor, die ebenfalls in Fig. 1 dargestellt ist. In dem Polysiliciumreaktor ist eine Reihenschaltung von Siliciumstäben oder Siliciumdünnstäben zur Herstellung von Polysilicium nach dem Siemensverfahren angeordnet. Auch die Reihenschaltung 2 ist in Figur 1 dargestellt. Dabei ist die Reihenschaltung 2 als Last an die Stromversorgungsanordnung 1 anschließbar. Die Stromversorgungsanordnung 1 ist mit einem Transformator 1 1 , dessen Primärseite 111 an ein Spannungsversorgungsnetz L1, N anschließbar ist und dessen Sekundärseite 112 mehrere Anzapfungen 1121, 1122, 1123 aufweist, mit einer Steuerung 12 und mit der Anordnung 10 zur Erdschlussüberwachung ausgestattet. Eine Anzapfung 1123 der Sekundärseite 112 ist mit einem Neutralleiteranschluss eines Ausgangs der Stromversorgungsanordnung 1 verbunden und wenigstens zwei Anzapfungen 1121, 1122 sind über Leistungssteller 13 mit einem Außenleiteranschluss des Ausgangs der Stromversorgungsanordnung verbunden. Die Anschlüsse des Ausgangs sind mit dem Neutralleiter N' und einem Außenleiter L1' verbunden. Mittels der Steuerung 12 sind die Leistungssteller 13 der Stromversorgungsanordnung 1 in Spannungsfolgesteuerung steuerbar.

Bei der bekannten Anordnung 10 zur Erdschlussüberwachung, wie sie in der Stromversorgungsanordnung 1 für einen Polysiliciumreaktor eingesetzt wird, fließt bei einem Erdschluss ein Strom über den Schutzleiter PE, den zweiten Anschluss 102 der Anordnung 10, die Reihenschaltung von ohmschen Widerständen R1, R2, R3 zum ersten Anschluss 101 der Anordnung 10 für die Erdschlussüberwachung und somit zum Neutralleiter N' der Stromversorgungsanordnung 1. Die Anordnung 10 zur Erdschlussüberwachung weist ein Mittel Iₘₐₓ zur Erkennung einer Stromstärke auf, welches einen vom zweiten Anschluss 102 zum ersten Anschluss 101 durch die Reihenschaltung von ohmschen Widerständen R1, R2, R3 fließenden Strom erkennt. Fließt über die Reihenschaltung R1, R2, R3 ein hinreichend großer Strom, wird von dem Mittel zur Erkennung der Stromstärke Iₘₐₓ ein Erdschluss erkannt.

Der aufgrund des Erdschlusses durch die Reihenschaltung von Widerständen R1, R2, R3 fließende Strom hat an jedem Widerstand R1, R2, R3 der Reihenschaltung einen Spannungsabfall gegenüber dem zweiten Anschluss 102 der Anordnung zur Erdschlussüberwachung zur Folge. Bei den bekannten Anordnungen zur Erdschlussüberwachung ist daher an zumindest einem Knoten 103 zwischen zwei Widerständen R2, R3 der Reihenschaltung ein Mittel Uₘₐₓ zur Erkennung einer Spannung angeschlossen, das eine Spannung über wenigstens einem der Widerstände R3 und dem zweiten Anschluss 102 der Anordnung zur Erdschlussüberwachung erkennt.

Das Mittel Iₘₐₓ zur Erkennung des Stroms und das Mittel Uₘₐₓ zur Erkennung der Spannung weisen Ausgänge auf, die über einen Bus und eine Schnittstelle 103 mit der Steuerung 12 der Stromversorgungsanordnung verbunden sind.

In der Steuerung können die über die Schnittstelle 103 von der Anordnung 10 abgegebenen Signale ausgewertet werden, um bei einem Erdschluss geeignete Maßnahmen in die Wege zu leiten, zum Beispiel das Abschalten der Stromversorgungsanordnung 1.

Eine Anordnung 10 zur Erdschlussüberwachung der eingangs genannten Art in einer Stromversorgungsanordnung 1 für einen Polysiliciumreaktor der eingangs genannten Art funktioniert insbesondere bei einer hochohmigen Verbindung zwischen dem Neutralleiter N' und dem Schutzleiter PE über zumindest einen Teil der von der Stromversorgungsanordnung 1 versorgten Reihenschaltung 2 der Siliciumstäbe oder Siliciumdünnstäbe hinreichend zuverlässig. Grundsätzlich kann mit einer derartigen Anordnung 10 zur Erdschlussüberwachung auch eine niederohmige Verbindung zwischen dem Neutralleiter N' und dem Schutzleiter PE über einen Teil der von der Stromversorgungsanordnung 1 versorgten Reihenschaltung 2 der Siliziumstäbe oder Siliziumdünnstäbe erkannt werden. In einem solchen Fall ist allerdings die zwischen dem Neutralleiter N' und dem Schutzleiter PE abfallende Spannung u.U. so gering, dass nur ein kleiner Strom über die Reihenschaltung der ohmschen Widerstände R1, R2, R3 der Anordnung 10 zur Erdschlussüberwachung getrieben wird. Das Mittel Iₘₐₓ zur Erkennung der Stromstärke des vom zweiten Anschluss 102 zum ersten Anschluss 101 durch die Reihenschaltung von ohmschen Widerständen R1, R2, R3 der Anordnung 10 zur Erdschlussüberwachung fließenden Stroms kann zwar einen solchen kleinen Strom grundsätzlich erfassen, es besteht allerdings dann die erhöhte Gefahr, dass aufgrund von nicht sicherheitsrelevanten Schlüssen oder anderen extrem kurzen Ereignissen ein Abschalten der gesamten Stromversorgungsanordnung 1 und somit ein Abbruch oder zumindest eine Unterbrechung des Prozesses zur Herstellung von Polysilicium erfolgt, was nicht gewünscht ist. Daher wird die

Schwelle, die der Strom durch die Reihenschaltung der ohmschen Widerstände R1, R2, R3 überschreiten muss, damit geeignete Sicherheitseinrichtungen ansprechen und die Stromversorgungsanordnung 1 abschalten, so hoch eingestellt, dass nicht sicherheitsrelevante Schlüsse oder andere extrem kurze Ereignisse kein Abschalten der Stromversorgungsanordnung bewirken. Damit spricht die Anordnung 10 zur Erdschlussüberwachung auch bei einer niederohmigen Verbindung zwischen dem Neutralleiter N' und dem Schutzleiter PE über einen Teil der von der Stromversorgungsanordnung versorgten Reihenschaltung 2 der Siliziumstäbe bzw. Siliziumdünnstäbe nicht an.

Ein weiterer Nachteil der bekannten Anordnung 10 zur Erdschlussüberwachung ist, dass bei einem Bruch in der Reihenschaltung von Widerständen R1, R2, R3 eine Erkennung eines Erdschlusses nicht mehr möglich ist. Es ist daher wünschenswert, wenn ein Bruch in der Reihenschaltung von Widerständen R1, R2, R3 der Anordnung 10 zur Erdschlussüberwachung erkannt wird, so dass dann die Stromversorgungsanordnung 1 abgeschaltet werden kann, da diese nicht mehr über eine funktionierende Erdschlussüberwachung verfügt.

Der Erfindung liegt das Problem zu Grunde, eine Anordnung zur Erdschlussüberwachung so zu verbessern, dass niederohmige Erdschlüsse sicher von nicht kritischen Zuständen unterschieden werden können und auch Ausfälle der Anordnung zur Erdschlussüberwachung durch Brüche in der Reihenschaltung von ohmschen Widerständen erkannt werden können.

Bezüglich der Erkennung von Brüchen in der Reihenschaltung von ohmschen Widerständen wird das Problem dahingehend gelöst, dass die Anordnung wenigstens ein Mittel zur Brucherkennung eines der Widerstände der Reihenschaltung aufweist. Liegt ein Bruch in der Reihenschaltung vor, kann dieser erkannt und ein Ausfall der Anordnung zur Erdschlussüberwachung signalisiert werden, der zu einer Abschaltung der Stromversorgungsanordnung führt.

Bezüglich der sicheren Erkennung von niederohmigen Erdschlüssen wird das Problem dahingehend gelöst, dass die Anordnung ein Mittel zum Integrieren eines durch die Reihenschaltung vom ersten Anschluss zum zweiten Anschluss fließenden Stroms aufweist. Durch die Integration des Stroms kann die Energie erfasst werden, die über den Erdschluss abfließt. Erreicht diese einen kritischen Betrag, kann ein niederohmiger Erdschluss sicher von einem nicht sicherheitsrelevanten Ereignis unterschieden werden.

Beide Lösungen können zusammen oder nebeneinander in einer Anordnung zur Erdschlussüberwachung eingesetzt werden.

Ein erstes der Mittel zur Brucherkennung kann eine erste Spannungsquelle und ein erstes Koppelnetzwerk aufweisen, über welches wenigstens ein erster der Widerstände der Reihenschaltung an die erste Spannungsquelle angeschlossen ist. Das Koppelnetzwerk kann ein Transformator sein, durch den die erste Spannungsquelle galvanisch von dem ersten Widerstand getrennt ist. Das erste Mittel zur Brucherkennung kann ein erstes Mittel zur Erkennung einer Stromstärke aufweisen, welches einen von der ersten Spannungsquelle getriebenen Strom durch den ersten Widerstand erkennt. Alternativ kann das erste Mittel zur Erkennung einer Stromstärke auch den durch die erste Spannungsquelle fließenden Strom erfassen.

Das erste Mittel zur Brucherkennung kann außerdem eine zweite Spannungsquelle und ein zweites Koppelnetzwerk aufweisen, über welches wenigstens ein zweiter der Widerstände an die zweite Spannungsquelle angeschlossen ist. Auch das zweite Koppelnetzwerk kann durch einen Transformator gebildet sein. Das erste Mittel zur Brucherkennung kann ein zweites Mittel zur Erkennung einer Stromstärke aufweisen, welches einen von der zweiten Spannungsquelle getriebenen Strom durch den zweiten Widerstand erkennt. Das zweite Mittel zur Erkennung einer Stromstärke könnte alternativ den Strom durch die zweite Spannungsquelle erfassen.

Der erste Widerstand und zweite Widerstand können in der Reihenschaltung der Widerstände unmittelbar hintereinander liegen. Zwischen ihnen ist dann ein gemeinsamer Knotenpunkt vorgesehen.

Die Summe der von der ersten Spannungsquelle bereitgestellten und über dem ersten Widerstand abfallenden Spannung und der von der zweiten Spannungsquelle bereitgestellten und über dem zweiten Widerstand abfallenden Spannung ist vorzugsweise gleich null oder annährend gleich null. Über der Reihenschaltung aus dem ersten Widerstand und dem zweiten Widerstand fällt daher aufgrund der Brucherkennung keine Spannung ab. Über der Reihenschaltung aus dem ersten Widerstand und dem zweiten Widerstand fällt aber im Fall des Erdschlusses eine Spannung ab, die von einem Mittel zur Erkennung einer Spannung erkannt werden kann, das Teil einer erfindungsgemäßen Anordnung sein kann.

Eine erfindungsgemäße Anordnung kann wenigstens ein zweites Mittel zur Brucherkennung aufweisen. Das zweite Mittel zur Brucherkennung kann eine dritte Spannungsquelle und ein drittes Koppelnetzwerk aufweisen, über welches wenigstens ein dritter der Widerstände an die dritte Spannungsquelle angeschlossen ist. Das dritte Kopplungsnetzwerk kann durch einen Transformator gebildet sein. Das zweite Mittel zur Brucherkennung kann ein drittes Mittel zur

Erkennung einer Stromstärke aufweisen, welches einen von der dritten Spannungsquelle getriebenen Strom durch den dritten Widerstand oder einen Strom durch die dritte Stromquelle erkennt.

Eine erfindungsgemäße Anordnung kann ein viertes Mittel zur Erkennung einer Stromstärke aufweisen, welches einen vom ersten Anschluss zum zweiten Anschluss durch die Reihenschaltung fließenden Strom erkennt.

Die Anordnung kann einen Zweig aufweisen, der den ersten Anschluss, einen Knotenpunkt zwischen zwei Widerständen der Reihenschaltung, einen weiteren Knotenpunkt zwischen zwei Widerständen der Reihenschaltung und/oder den zweiten Anschluss miteinander verbindet und der eine vierte Spannungsquelle und einen steuerbaren Schalter aufweist, der zu diskreten Zeitpunkten mittels einer Steuerung zum Schließen ansteuerbar ist. Zu den diskreten Zeitpunkten sind vorteilhaft das erste Mittel zur Brucherkennung und das zweite Mittel zur Brucherkennung außer Betrieb. Im geschlossenen Zustand des Schalters kann von der vierten Spannungsquelle ein Strom über den Schalter, den ersten Anschluss einen Knotenpunkt zwischen zwei Widerständen der Reihenschaltung, einen weiteren Knotenpunkt zwischen zwei Widerständen der Reihenschaltung und/oder den zweiten Anschluss somit über wenigstens einen Teil der Reihenschaltung aus den ohmschen Widerständen getrieben werden. Ein fünftes Mittel zur Erkennung einer Stromstärke kann dann einen über den Schalter fließenden Strom erkennen. Fließt trotz des geschlossenen steuerbaren Schalters kein von der vierten Spannungsquelle getriebener Strom, kann ein Bruch in der Reihenschaltung der ohmschen Widerstände der erfindungsgemäßen Anordnung vorliegen. Bei dem steuerbaren Schalter kann es sich um ein Relais handeln.

Die Mittel zur Erkennung eines Stroms in einer erfindungsgemäßen Anordnung können Stromrelais sein.

Weitere Merkmale und Vorteile der vorliegenden Erfindung werden anhand der beiliegenden Abbildungen beschrieben. Darin zeigen
- Fig. 2: eine erste erfindungsgemäße Anordnung zur Erdschlussüberwachung und
- Fig. 3: eine zweite erfindungsgemäße Anordnung zur Erdschlussüberwachung.

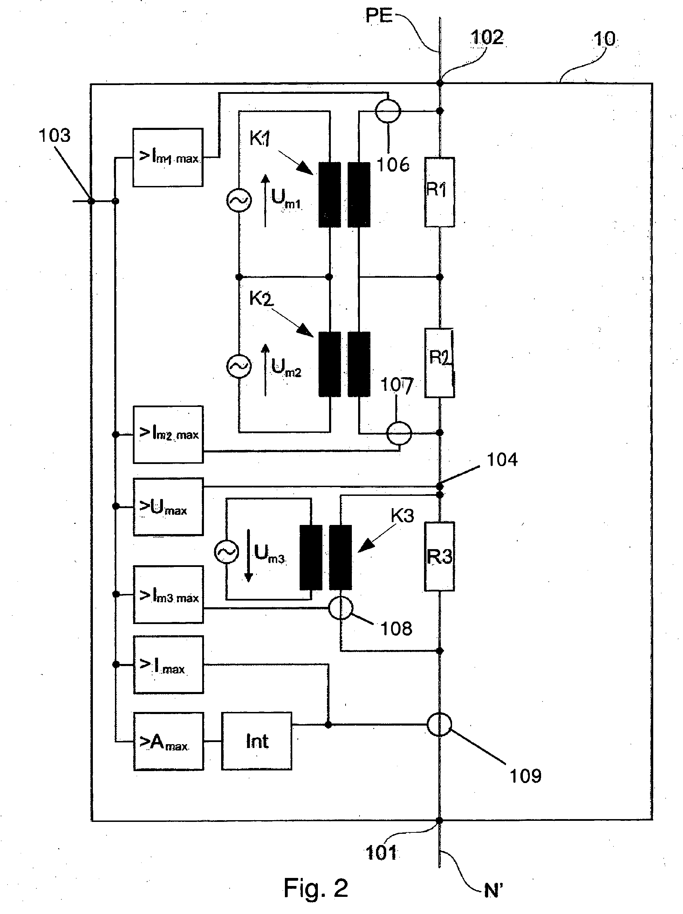

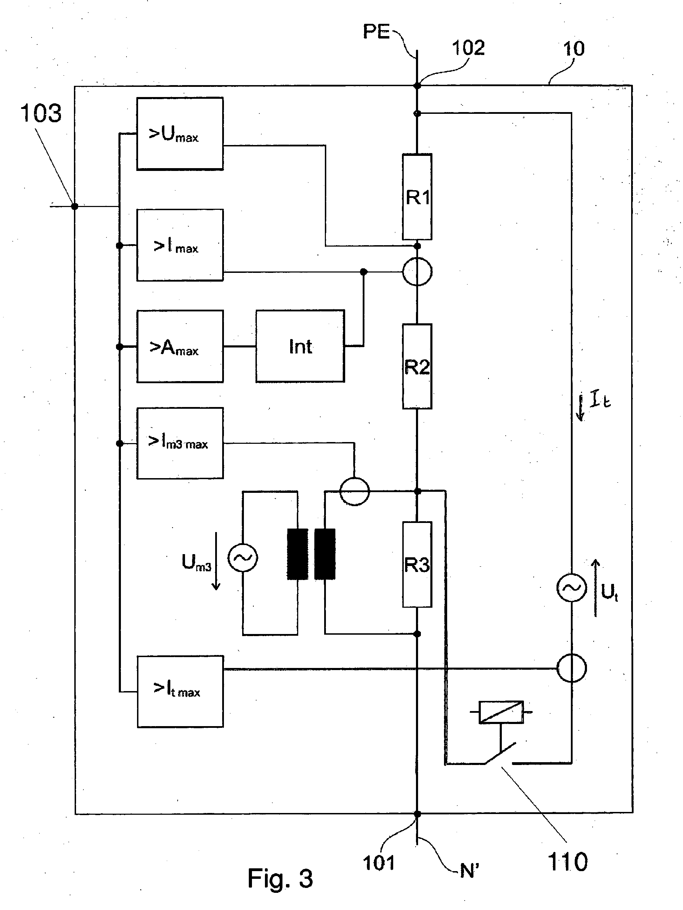

Die in den Figuren 1, 2, 3 dargestellten Anordnungen zur Erdschlussüberwachung bzw. Stromversorgungsanordnungen mit Erdschlussüberwachungen weisen eine Vielzahl von gleichen oder funktional gleichen Bauelementen und Komponenten auf. Diese Bauelemente oder Komponenten sind in den Figuren mit gleichen Bezugszeichen bezeichnet. Bauelemente, Komponenten und/oder Teile der beiden in den Figuren 2 und 3 dargestellten erfindungsgemäßen Anordnungen können ganz oder teilweise miteinander kombiniert werden, um weitere erfindungsgemäße Anordnungen zu schaffen.

Die in den Figuren 2 und 3 dargestellten Anordnungen 10 zur Erdschlussüberwachung können anstelle der in der Figur 1 dargestellten Anordnung 10 zur Erdschlussüberwachung in der in der Figur 1 ebenfalls dargestellten Stromversorgungsanordnung eingesetzt werden.

Die in Figur 2 dargestellte Anordnung 10 zur Erdschlussüberwachung weist ein erstes Mittel zur Brucherkennung auf. Das erste Mittel zur Brucherkennung umfasst eine erste Spannungsquelle Uₘ₁ und ein erstes Koppelnetzwerk K1, dass durch einen Transformator gebildet wird. Die erste Spannungsquelle Uₘ₁ ist primärseitig mit dem Transformator K1 verbunden. Sekundärseitig ist ein erster Widerstand R1 der Reihenschaltung der Widerstände R1, R2, R3 der Anordnung 10 zur Erdschlussüberwachung angeschlossen.

Das erste Mittel zur Brucherkennung umfasst ferner eine zweite Spannungsquelle Uₘ₂ und ein zweites Koppelnetzwerk K2, dass ebenfalls durch einen Transformator gebildet wird. Die zweite Spannungsquelle Uₘ₂ ist primärseitig mit dem Transformator K2 verbunden. Sekundärseitig ist ein zweiter Widerstand R2 der Reihenschaltung der Widerstände R1, R2, R3 der Anordnung 10 zur Erdschlussüberwachung angeschlossen.

Die erste Spannungsquelle Uₘ₁, die zweite Spannungsquelle Uₘ₂, der Transformator K1 und der Transformator K2 sind so angeordnet und die von der Spannungsquelle Uₘ₁, Uₘ₂ zur Verfügung gestellten Spannungen sind so bemessen, dass sich die sekundärseitigen Spannungen aufheben und über der Reihenschaltung aus dem ersten Widerstand R1 und dem zweiten Widerstand R2 in der Summe keine Spannung abfällt, die auf die erste Spannungsquelle Uₘ₁ oder die zweite Spannungsquelle Uₘ₂ zurückzuführen wäre. Über der Reihenschaltung aus dem ersten Widerstand R1 und dem zweiten Widerstand R2 kann allenfalls eine Spannung abfallen, die auf eine gegenüber dem ersten Mittel zur Brucherkennung äußere Spannungsquelle zurückzuführen ist.

Das erste Mittel zur Brucherkennung umfasst ferner ein erstes Mittel Iₘ₁ₘₐₓ zur Erkennung einer Stromstärke, zum Beispiel ein Stromrelais, welches einen von der ersten Spannungsquelle Uₘ₁ durch den ersten Widerstand R1 getriebenen Strom Iₘ₁ erkennt. Dazu weist das erste Mittel Iₘ₁ₘₐₓ zur Erkennung der Stromstärke ein Erfassungselement 106 auf, das in dem von der Sekundärseite des Transformators K1 und dem ersten Widerstand R1 gebildeten Stromkreis angeordnet ist. Das Erfassungselement 106 ist dabei in Reihe zu der Sekundärseite des Transformators angeordnet.

Ist der Strom Iₘ₁ durch den ersten Widerstand R1 hinreichend groß, ist sichergestellt, dass der erste Widerstand R1 nicht gebrochen ist. Ist der Strom Iₘ₁ jedoch nicht vorhanden, muss davon ausgegangen werden, dass der erste Widerstand R1 defekt ist.

Das erste Mittel zur Brucherkennung umfasst auch ein zweites Mittel Iₘ₂ₘₐₓ zur Erkennung einer Stromstärke, ebenfalls ein Stromrelais, welches einen von der zweiten Spannungsquelle Uₘ₂ durch den zweiten Widerstand R2 getriebenen Strom Iₘ₂ erkennt. Ist auch hier der Strom Iₘ₂ durch den Widerstand R2 hinreichend, ist sichergestellt, dass der Widerstand R2 nicht gebrochen ist. Ist der Strom Iₘ₂ nicht vorhanden, muss davon ausgegangen werden, dass der zweite Widerstand R2 gebrochen ist.

Das zweite Mittel Iₘ₂ₘₐₓ zur Erkennung der Stromstärke weist ein Erfassungselement 107 auf, das in dem von der Sekundärseite des Transformators K2 und dem zweiten Widerstand R2 gebildeten Stromkreis angeordnet ist. Das Erfassungselement 107 ist dabei in Reihe zu der Sekundärseite des Transformators K2 angeordnet, so dass nur der Strom Iₘ₂ durch das Erfassungselement 107 fließen kann.

Die in der Figur 3 dargestellte Anordnung 10 zur Erdschlussüberwachung weist ferner ein zweites Mittel zur Brucherkennung auf. Das zweite Mittel zur Brucherkennung umfasst eine dritte Spannungsquelle Uₘ₃, ein drittes Koppelnetzwerk K3 und ein drittes Mittel Iₘ₃ₘₐₓ zur Erkennung einer Stromstärke, welches einen von der dritten Spannungsquelle Uₘ₃ getriebenen Strom durch den Widerstand R3 erkennt. Der dritte Widerstand R3 ist über das Koppelnetzwerk K3, welches ebenfalls durch einen Transformator gebildet ist, an die dritte Spannungsquelle Uₘ₃ angeschlossen. Das dritte Mittel Iₘ₃ₘₐₓ umfasst ein Erfassungselement 108, welches in Reihe zu der Sekundärseite des Transformators K3 angeordnet ist. Auch das dritte Mittel Iₘ₃ₘₐₓ zur Erkennung der Stromstärke kann ein Stromrelais sein.

Sofern der dritte Widerstand R3 nicht gebrochen ist, kann die dritte Spannungsquelle Uₘ₃ einen Strom durch den von der Sekundärseite des Transformators K3, dem Erfassungselement 108 und dem dritten Widerstand R3 gebildeten Stromkreis treiben. Ist der dritte Widerstand R3 dagegen gebrochen, kann dieser Strom nicht mehr fließen. Das dritte Mittel Iₘ₃ₘₐₓ zur Erkennung der Stromstärke erkennt das und meldet den Bruch über den Ausgang 103 der Anordnung an die Steuerung 12 der Stromversorgungsanordnung 1.

Die erfindungsgemäße Anordnung 10 gemäß Figur 2 umfasst ferner ein viertes Mittel Iₘₐₓ zur Erkennung einer Stromstärke, welches einen vom zweiten Anschluss 102 zum ersten Anschluss 101 durch die Reihenschaltung R1, R2, R3 fließenden Strom erkennt. Dazu weist das vierte Mittel Iₘₐₓ ein Erfassungselement 109 auf, welches hinter dem ersten Anschluss 101 angeordnet ist. Auch beim vierten Mittel Iₘₐₓ kann es sich um ein Stromrelais handeln. Über die Reihenschaltung aus den Widerständen R1, R2, R3 fließt im Falle des Erdschlusses ein Strom, der von dem vierten Mittel Iₘₐₓ erkannt und über den Anschluss 103 der Anordnung 10 an die Steuerung 12 der Stromversorgungsanordnung 1 gemeldet wird.

Das Erfassungselement 109 ist ferner mit einem Mittel Iₙₜ zum Integrieren verbunden, der den erfassten Strom integriert. Die Integration des durch die Reihenschaltung der Widerstände R1, R2, R3 fließenden Stroms steht für die beim Erdschluss fließende Energie. Die Größe der abfließenden Energien können zur Unterscheidung eines Erdschlusses von einem anderen nicht sicherheitskritischen Phänomen benutzt werden.

Schließlich umfasst die in der Figur 2 dargestellte Anordnung ein Mittel Uₘₐₓ zur Erkennung einer Spannung, das die zwischen einem zwischen den Widerständen R2 und R3 gelegenen Knoten 104 und dem zweiten Anschluss, d.h. dem Schutzleiter PE abfallende Spannung erfasst. Fließt aufgrund eines Erdschlusses ein Strom über die Reihenschaltung der Widerstände R1, R2, R3, fällt über die Reihenschaltung aus den Widerständen R1, R2 eine Spannung ab. Diese Spannung wird von dem Mittel Uₘₐₓ erkannt und kann von der Steuerung als Indikator für einen Erdschluss verwendet werden.

Die in der Figur 3 dargestellte erfindungsgemäße Anordnung 10 entspricht in weiten Teilen der in Figur 2 dargestellten. Im Unterschied zu der in der Figur 2 dargestellten Anordnung weist die in der Figur 3 dargestellte Anordnung 10 kein erstes Mittel zur Brucherkennung auf. Es ist lediglich das zweite Mittel zur Brucherkennung vorgesehen, mit welchem der dritte Widerstand R3 kontinuierlich auf Bruch überwacht werden kann.

Eine kontinuierliche Brucherkennung findet für die Widerstände R1 und R2 dagegen nicht statt. Es ist allerdings ein Mittel vorgesehen, mit dem die Widerstände R1 und R2 zu diskreten Zeitpunkten auf einen Bruch überprüft werden können, zum Beispiel vor dem Beginn einer Versorgung der Reihenschaltung 2 mit Strom aus der Stromversorgungsanordnung 1.

Das Mittel zur Brucherkennung zu diskreten Zeitpunkten umfasst einen Zweig, der den ersten Anschluss 101 und den knoten 104 miteinander verbindet und der eine vierte Spannungsquelle Uₜ und einen steuerbaren Schalter 110 aufweist, der zu diskreten Zeitpunkten mittels einer Steuerung 1.2 zum Schließen ansteuerbar ist. Im geschlössenen Zustand des Schalters treibt die vierte Spannungsquelle Uₜ einen Strom It über den Schalter 110 und Widerstände R1 und R2. Der durch den Zweig fließende Strom Iₜ wird von einem fünften Mittel Iₜₘₐₓ zur Erkennung einer Stromstärke erfasst. Damit kann zu den diskreten Zeitpunkten festgestellt werden, ob die Widerstände R1 und R2 gebrochen sind oder nicht. Der Ausgang des fünften Mittels Iₜₘₐₓ zur Erkennung der Stromstärke ist über die Schnittstelle 103 mit der Steuerung 12 verbunden.

## Patentansprüche

1. Anordnung (10) zur Erdschlussüberwachung eines Wechselstromkreises zwischen einem Neutralleiter (N') des Wechselstromkreises einerseits und einem Schutzleiter (PE) oder einem Erder andererseits mit einer Reihenschaltung von ohmschen Widerständen (R1, R2, R3), die einen ersten Anschluss (101) für den Neutralleiter(N') und einen zweiten Anschluss (102) für den Schutzleiter (PE) oder den Erder aufweist,
**dadurch gekennzeichnet,**
**dass** die Anordnung wenigstens ein Mittel zur Brucherkennung eines der Widerstände (R1, R2, R3) der Reihenschaltung aufweist.

2. Anordnung nach Anspruch 1 , **dadurch gekennzeichnet, dass** ein erstes der Mittel zur Brucherkennung eine erste Spannungsquelle (Uₘ₁) und ein erstes Koppelnetzwerk (K1) aufweist, über welches wenigstens ein erster Widerstand (R1) der Widerstände (R1, R2, R3) an die erste Spannungsquelle (Uₘ₁) angeschlossen ist.

3. Anordnung nach Anspruch 2, **dadurch gekennzeichnet, dass** das erste Mittel zur Brucherkennung ein erstes Mittel (Iₘ₁ₘₐₓ) zur Erkennung einer Stromstärke aufweist, welches einen von der ersten Spannungsquelle getriebenen Strom (Iₘ₁) durch den ersten Widerstand (R1) erkennt.

4. Anordnung nach Anspruch 3, **dadurch gekennzeichnet, dass** das erste Mittel zur Brucherkennung eine zweite Spannungsquelle (Uₘ₂) und ein zweites Koppelnetzwerk (K2) aufweist, über welches wenigstens ein zweiter Widerstand (R2) der Widerstände (R1, R2, R3) an die zweite Spannungsquelle (Uₘ₂) angeschlossen ist.

5. Anordnung nach Anspruch 4, **dadurch gekennzeichnet, dass** das erste Mittel zur Brucherkennung ein zweites Mittel (Iₘ₂ₘₐₓ) zur Erkennung einer Stromstärke aufweist, welches einen von der zweiten Spannungsquelle (Uₘ₂) getriebenen Strom (Iₘ₂) durch den zweiten Widerstand (R2) erkennt.

6. Anordnung nach Anspruch 5, **dadurch gekennzeichnet, dass** der erste Widerstand (R1) und der zweite Widerstand (R2) in der Reihenschaltung der Widerstände (R1, R2, R3) unmittelbar hintereinander liegen.

7. Anordnung nach Anspruch 6, **dadurch gekennzeichnet, dass** die Summe der von der ersten Spannungsquelle (Uₘ₁) bereitgestellten und über dem ersten Widerstand (R1) abfallenden Spannung und der von der zweiten Spannungsquelle (Uₘ₂) bereitgestellten und über dem zweiten Widerstand (R2) abfallenden Spannung gleich null oder annährend gleich null ist.

8. Anordnung nach einem der Ansprüche 1 bis 7, **dadurch gekennzeichnet, dass** die Anordnung (10) ein zweites Mittel zur Brucherkennung aufweist und das zweite Mittel zur Brucherkennung eine dritte Spannungsquelle (Uₘ₃) und ein drittes Koppelnetzwerk (K3) aufweist, über welches wenigstens ein dritter Widerstand (R3) der Widerstände (R1, R2, R3) an die dritte Spannungsquelle (Uₘ₃) angeschlossen ist.

9. Anordnung nach Anspruch 8, **dadurch gekennzeichnet, dass** das zweite Mittel zur Brucherkennung ein drittes Mittel (Iₘ₃ₘₐₓ) zur Erkennung einer Stromstärke aufweist, welches einen von der dritten Spannungsquelle (Uₘ₃) getriebenen Strom (Iₘ₃) durch den dritten Widerstand (R3) erkennt.

10. Anordnung nach einem der Ansprüche 1 bis 9, **dadurch gekennzeichnet, dass** die Anordnung ein viertes Mittel (Iₘₐₓ) zur Erkennung einer Stromstärke aufweist, welches einen vom zweiten Anschluss (102) zum ersten Anschluss (101) durch die Reihenschaltung der Widerstände (R1, R2, R3) fließenden Strom (I) erkennt.

11. Anordnung nach einem der Ansprüche 1 bis 10, **dadurch gekennzeichnet, dass** die Anordnung ein Mittel (Int) zum Integrieren eines durch die Reihenschaltung der Widerstände (R1, R2, R3) fließenden Stroms (I) aufweist.

12. Anordnung nach einem der Ansprüche 1 bis 11, **dadurch gekennzeichnet, dass** die Anordnung (10) einen Zweig aufweist, der parallel zu zumindest einem Teil der Widerstände (R1, R2) der Reihenschaltung liegt und der eine vierte Spannungsquelle (Uₜ) und einen steuerbaren Schalter (110) aufweist, der zu diskreten Zeitpunkten mittels einer Steuerung (12) zum Schließen ansteuerbar ist.

13. Anordnung nach Anspruch 12, **dadurch gekennzeichnet, dass** im geschlossenen Zustand des Schalters (110) die vierte Spannungsquelle (Ut) ein Strom (Iₜ) über den Schalter (110) treibt.

14. Anordnung nach Anspruch 12 oder 13, **dadurch gekennzeichnet, dass** die Anordnung (10) ein fünftes Mittel (Iₜₘₐₓ) zur Erkennung einer Stromstärke aufweist, welches den über den Schalter (110) fließenden Strom (Iₜ) erkennt.

15. Stromversorgungsanordnung (1) für einen Polysiliciumreaktor, in dem eine Reihenschaltung (2) von Sliciumstäben oder Siliciumdünnstäben zur Herstellung von Polysilicium nach dem Siemensverfahren angeordnet ist, wobei die Reihenschaltung (2) als Last an die Stromversorgungsanordnung (1) anschließbar ist, mit einem Transformator (11), dessen Primärseite (111) an ein Spannungsversorgungsnetz (L1 , N) anschließbar ist und dessen Sekundärseite (112) mehrere Anzapfungen (1121, 1122, 1123) aufweist, wobei eine Anzapfung (1123) mit einem Neutralleiteranschluss eines Ausgangs der Stromversorgungsanordnung verbunden ist und wenigstens zwei Anzapfungen (1121, 1122) über Leistungssteller (13) mit einem Außenleiteranschluss des Ausgangs der Stromversorgungsanordnung verbunden sind, mit einer Steuerung (12), mittels der die Leistungssteller (13) der Stromversorgungsanordnung (1) in Spannungsfolgesteuerung steuerbar sind, und mit einer Anordnung (10) zur Erdschlussüberwachung,
**dadurch gekennzeichnet,**
**dass** die Anordnung (10) zur Erdschlussüberwachung nach einem der Ansprüche 1 bis 14 ausgebildet ist.

## Claims

1. Arrangement (10) for earth fault monitoring of an AC circuit between a neutral conductor (N') of the AC circuit, on the one hand, and a PE conductor (PE) or an earth electrode, on the other hand, comprising a series circuit of ohmic resistors (R1, R2, R3), which series circuit has a first connection (101) for the neutral conductor (N') and a second connection (102) for the PE conductor (PE) or the earth electrode, **characterized in that** the arrangement has at least one means for breakage identification for one of the resistors (R1, R2, R3) in the series circuit.

2. Arrangement according to Claim 1, **characterized in that** a first of the means for breakage identification has a first voltage source (Uₘ₁) and a first coupling network (K1), via which at least one first resistor (R1) of the resistors (R1, R2, R3) is connected to the first voltage source (Uₘ₁).

3. Arrangement according to Claim 2, **characterized in that** the first means for breakage identification has a first means (Iₘ₁ₘₐₓ) for identifying a current, which first means identifies a current (Iₘ₁) driven by the first voltage source, through the first resistor (R1).

4. Arrangement according to Claim 3, **characterized in that** the first means for breakage identification has a second voltage source (Uₘ₂) and a second coupling network (K2), via which at least one second resistor (R2) of the resistors (R1, R2, R3) is connected to the second voltage source (Uₘ₂).

5. Arrangement according to Claim 4, **characterized in that** the first means for breakage identification has a second means (Iₘ₂ₘₐₓ) for identifying a current, which second means identifies a current (Iₘ₂) driven by the second voltage source (Uₘ₂), through the second resistor (R2).

6. Arrangement according to Claim 5, **characterized in that** the first resistor (R1) and the second resistor (R2) are directly one behind the other in the series circuit of resistors (R1, R2, R3).

7. Arrangement according to Claim 6, **characterized in that** the sum of the voltage drop across the first resistor (R1) provided by the first voltage source (Uₘ₁) and the voltage drop across the second resistor (R2) provided by the second voltage source (Uₘ₂) is equal to zero or is approximately equal to zero.

8. Arrangement according to one of Claims 1 to 7, **characterized in that** the arrangement (10) has a second means for breakage identification, and the second means for breakage identification has a third voltage source (Uₘ₃) and a third coupling network (K3), via which at least one third resistor (R3) of the resistors (R1, R2, R3) is connected to the third voltage source (Uₘ₃).

9. Arrangement according to Claim 8, **characterized in that** the second means for breakage identification has a third means (Iₘ₃ₘₐₓ) for identifying a current, which third means identifies a current (Iₘ₃) driven by the third voltage source (Uₘ₃), through the third resistor (R3).

10. Arrangement according to one of Claims 1 to 9, **characterized in that** the arrangement has a fourth means (Iₘₐₓ) for identifying a current, which fourth means identifies a current (I) flowing from the second connection (102) to the first connection (101) through the series circuit of resistors (R1, R2, R3).

11. Arrangement according to one of Claims 1 to 10, **characterized in that** the arrangement has a means (Int) for integrating a current (I) flowing through the series circuit of resistors (R1, R2, R3).

12. Arrangement according to one of Claims 1 to 11, **characterized in that** the arrangement (10) has a branch, which is in parallel with at least some of the resistors (R1, R2) in the series circuit and which has a fourth voltage source (Uₜ) and a controllable switch (110), which is actuable for closing purposes by means of a controller (12) at discrete times.

13. Arrangement according to Claim 12, **characterized in that**, in the closed state of the switch (110), the fourth voltage source (Ut) drives a current (Iₜ) via the switch (110).

14. Arrangement according to Claim 12 or 13, **characterized in that** the arrangement (10) has a fifth means (Iₜₘₐₓ) for identifying a current, which fifth means identifies the current (Iₜ) flowing via the switch (110).

15. Power supply arrangement (1) for a polysilicon reactor, in which a series circuit (2) of silicon rods or thin silicon rods is arranged so as to produce polysilicon in accordance with the Siemens method, wherein the series circuit (2) is connectable as load to the power supply arrangement (1), comprising a transformer (11), whose primary side (111) is connectable to a voltage supply grid (L1, N) and whose secondary side (112) has a plurality of taps (1121, 1122, 1123), wherein a tap (1123) is connected to a neutral conductor connection of an output of the power supply arrangement, and at least two taps (1121, 1122) are connected to an outer conductor connection of the output of the power supply arrangement via power controllers (13), comprising a controller (12) by means of which the power controllers (13) of the power supply arrangement (1) are controllable using voltage-sequencing control, and comprising an arrangement (10) for earth fault monitoring, **characterized in that** the arrangement (10) for earth fault monitoring is designed according to one of Claims 1 to 14.

## Revendications

1. Arrangement (10) destiné à surveiller une liaison de terre d'un circuit à courant alternatif entre un conducteur neutre (N') du circuit à courant alternatif d'un côté et un conducteur de protection (PE) ou une prise de terre de l'autre côté, comprenant un circuit série constitué de résistances ohmiques (R1, R2, R3) qui présente une première borne (101) pour le conducteur neutre (N') et une deuxième borne (102) pour le conducteur de protection (PE) ou la borne de terre,
**caractérisé en ce**
**que** l'arrangement présente au moins un moyen de détection de rupture de l'une des résistances (R1, R2, R3) du circuit série.

2. Arrangement selon la revendication 1, **caractérisé en ce qu'**un premier des moyens de détection de rupture présente une première source de tension (Uₘ₁) et un premier réseau de connexion (K1) par le biais duquel au moins une première résistance (R1) des résistances (R1, R2, R3) est raccordée à la première source de tension (Uₘ₁).

3. Arrangement selon la revendication 2, **caractérisé en ce que** le premier moyen de détection de rupture présente un premier moyen (Iₘ₁ₘₐₓ) servant à la détection d'un courant, lequel détecte un courant (Iₘ₁) conduit par la première source de tension à travers la première résistance (R1).

4. Arrangement selon la revendication 3, **caractérisé en ce que** le premier de moyen de détection de rupture présente une deuxième source de tension (Uₘ₂) et un deuxième réseau de connexion (K2) par le biais duquel au moins une deuxième résistance (R2) des résistances (R1, R2, R3) est raccordée à la deuxième source de tension (Uₘ₂).

5. Arrangement selon la revendication 4, **caractérisé en ce que** le premier moyen de détection de rupture présente un deuxième moyen (Iₘ₂ₘₐₓ) servant à la détection d'un courant, lequel détecte un courant (Iₘ₂) produit par la deuxième source de tension (Uₘ₂) à travers la deuxième résistance (R2).

6. Arrangement selon la revendication 5, **caractérisé en ce que** la première résistance (R1) et la deuxième résistance (R2) se trouvent directement l'une derrière l'autre dans le circuit série des résistances (R1, R2, R3).

7. Arrangement selon la revendication 6, **caractérisé en ce que** la somme de la tension délivrée par la première source de tension (Uₘ₁) et en chute au niveau de la première résistance (R1) et de la tension délivrée par la deuxième source de tension (Uₘ₂) et en chute au niveau de la deuxième résistance (R2) est égale à zéro ou approximativement égale à zéro.

8. Arrangement selon l'une des revendications 1 à 7, **caractérisé en ce que** l'arrangement (10) présente un deuxième moyen de détection de rupture et le deuxième moyen de détection de rupture présente une troisième source de tension (Uₘ₃) et un troisième réseau de connexion (K3) par le biais duquel au moins une troisième résistance (R3) des résistances (R1, R2, R3) est raccordée à la troisième source de tension (Uₘ₃).

9. Arrangement selon la revendication 8, **caractérisé en ce que** le deuxième moyen de détection de rupture présente un troisième moyen (Iₘ₃ₘₐₓ) servant à la détection d'une intensité de courant, lequel détecte un courant (Iₘ₃) conduit par la troisième source de tension (Uₘ₃) à travers la troisième résistance (R3).

10. Arrangement selon l'une des revendications 1 à 9, **caractérisé en ce que** l'arrangement présente un quatrième moyen (Iₘₐₓ) servant à la détection d'une intensité de courant, lequel détecte un courant (I) qui circule de la deuxième borne (102) vers la première borne (101) à travers le circuit série constitué par les résistances (R1, R2, R3).

11. Arrangement selon l'une des revendications 1 à 10, **caractérisé en ce que** l'arrangement présente un moyen (Int) servant à l'intégration d'un courant (I) qui circule à travers le circuit série constitué par les résistances (R1, R2, R3).

12. Arrangement selon l'une des revendications 1 à 11, **caractérisé en ce que** l'arrangement (10) présente une branche qui est parallèle à au moins une partie des résistances (R1, R2) du circuit série et qui présente une quatrième source de tension (U₁) ainsi qu'un commutateur commandable (110) qui peut être commandé en fermeture à des instants discrets à l'aide d'une commande (12).

13. Arrangement selon la revendication 12, **caractérisé en ce qu'**en position fermée du commutateur (110), la quatrième source de tension (U₁) conduit un courant (Iₜ) par le biais du commutateur (110).

14. Arrangement selon la revendication 12 ou 13, **caractérisé en ce que** l'arrangement (10) présente un cinquième moyen (Iₜₘₐₓ) servant à la détection d'un courant, lequel détecte un courant (Iₜ) qui circule par le biais du commutateur (110).

15. Arrangement d'alimentation électrique (1) pour un réacteur en polysilicium dans lequel est disposé un circuit série (2) constitué de barreaux de silicium ou de baguettes de silicium servant à la fabrication de polysilicium selon le procédé Siemens, le circuit série (2) pouvant être raccordé en tant que charge à l'arrangement d'alimentation électrique (1), comprenant un transformateur (11) dont le côté primaire (111) peut être raccordé à un réseau d'alimentation électrique (L1, N) et dont le côté secondaire (112) présente plusieurs prises (1121, 1122, 1123), une prise (1123) étant reliée avec une borne de conducteur neutre d'une sortie de l'arrangement d'alimentation électrique et au moins deux prises (1121, 1122) étant reliées par le biais des éléments de réglage de puissance (13) avec une borne de conducteur externe de la sortie de l'arrangement d'alimentation électrique, comprenant une commande (12) à l'aide de laquelle les éléments de réglage de puissance (13) de l'arrangement d'alimentation électrique (1) peuvent être commandés en commande de succession de tension, et comprenant un arrangement (10) destiné à surveiller une liaison de terre,
**caractérisé en ce**
**que** l'arrangement (10) destiné à surveiller une liaison de terre est configuré selon l'une des revendications 1 à 14.
